# EUROPÄISCHE PATENTSCHRIFT

(11) **EP 0 503 351 B1**
(45) Veröffentlichungstag und Bekanntmachung des Hinweises auf die Patenterteilung: **27.03.1996**
(21) Anmeldenummer: 92103114.2
(22) Anmeldetag: 25.02.1992
(51) Int. Cl.: C23C 18/28

(54) **Hydroprimer zum Metallisieren von Substratoberflächen**
Primer for metallising substrates
Couche d'accrochage pour métallisation

(30) Priorität: 09.03.1991 DE 4107644
(43) Veröffentlichungstag der Anmeldung: 16.09.1992
(73) Patentinhaber: BAYER AG, D-51368 Leverkusen (DE)
(72) Erfinder: Wolf, Gerhard-Dieter, Dr., W-4047 Dormagen 1 (DE); von Gizycki, Ulrich, Dr., W-5090 Leverkusen 3 (DE); Cohnen, Wolfgang, Dr., W-5090 Leverkusen 1 (DE); Reichert, Günther, Dr., W-5000 Köln 80 (DE); Jabs, Gert, Dr., W-5068 Odenthal (DE)

(56) Entgegenhaltungen:
- EP-A- 0 327 057
- EP-A- 0 340 513
- DE-A- 2 635 457

## Beschreibung

Gegenstand der Erfindung sind Zubereitungen auf Basis wäßriger Dispersionen, die neben Wasser im wesentlichen wasserdispergierbare Polyurethane, Metallisierungsaktivatoren und vorzugsweise auch Füllstoffe enthalten.

Diese Zubereitungen dienen zur Vorbehandlung von verschiedenen Substratoberflächen, beispielsweise Kunststoffoberflächen mit dem Ziele der nachfolgenden Metallisierung in stromlosen Metallisierungsbädern.

Mit diesen Zubereitungen aktivierte Kunststoffteile werden nach erfolgter Metallisierung vorzugsweise zur Abschirmung von elektromagnetischen Wellen eingesetzt.

Es ist bekannt, daß polymere Werkstoffe vor der chemischen und der nachfolgenden galvanischen Metallisierung vorbehandelt werden müssen, um eine hinreichende Haftung der Metallschicht auf der Werkstoffoberfläche zu erzielen. Die Vorbehandlung erfolgt vorwiegend durch Ätzen der Polymeroberfläche mit umweltbelastenden Chromschwefelsäuren. Das Arbeiten mit Chromschwefelsäure, SO₃-Dampf oder anderen Oxidantien geht jedoch mit einer Verschlechterung der physikalischen Eigenschaften, wie der Schlagzähigkeit und des elektrischen Oberflächenwiderstands des polymeren Werkstoffs einher. Darüber hinaus stören oftmals Spuren von 6-wertigem Chrom, die rasch zu einer Vergiftung der Metallbäder führen können.

Die bekannten Verfahren zur stromlosen Metallisierung von Werkstoffen bestehen im übrigen aus mehreren Verfahrensstufen und haben den Nachteil, daß sie nicht direkt auf alle Polymeren anwendbar sind. Oftmals muß zusätzlich eine chemische Quellung oder eine physikalische Aufrauhung durchgeführt werden.

Es ist deshalb bereits vorgeschlagen worden, die Polymeroberflächen sehr schonend mit metallorganischen Katalysatoren zu aktivieren (DE-A 3 560 257 und EP-A 81 129). Diese fortschrittliche Methode ist indessen ebenfalls nicht universell anwendbar. Darüber hinaus führt der Einsatz von Lösungsmitteln häufig zur Auslösung der Spannungsrißkorrosion der unter Zug- oder Druckspannung stehenden Polymerspritzgußteile.

Andere Verfahren, wie sie in US-A 3 560 257 und 4 017 265 sowie DE-A 3 627 256 beschrieben werden, haben den Nachteil, daß sie größere Mengen an teueren Edelmetallaktivatoren erfordern.

Ferner sind aus der DE-A 3 814 506 spezielle haftvermittelnde Kunststoff-Lackierungen bekannt. Diese müssen aber vor ihrer Metallisierung in Aktivierungsbädern aktiviert werden, wodurch es in den Fällen der partiellen Metallisierung zur geometrieabhängigen Fremdabscheidung führen kann.

Aus DE-A 26 35 457 ist ein katalytischer Lack bekannt, der neben einem Bindemittel, Wasser, einem Metallsalz und einem Komplexbildner durch einen Gehalt an einem Reduktionsmittel gekennzeichnet ist. Das Redukionsmittel reduziert das Metall beim Trocknungsvorgang und bildet so Metallkeime aus.

Aufgabe der vorliegenden Erfindung war daher die Entwicklung eines ebenso wirtschaftlichen wie universell anwendbaren Verfahrens zur chemischen Metallisierung von Werkstoffoberflächen auf der Basis von Gläsern, Metallen und insbesondere von Kunststoffen, mit dem ohne vorheriges Ätzen mit Oxidantien auf den Substraten gut haftende, auf naßchemischem Wege abgeschiedene Metallüberzüge aufgebracht werden können, wobei jedoch die durch die Lösungsmittel hervorgerufenen Nachteile vermieden werden sollen.

Die Aufgabe wird dadurch gelöst, daß man Substratoberflächen mit einem speziellen Hydroprimer beschichtet, der im wesentlichen aus einer wäßrigen Dispersion eines polymeren organischen Film- bzw. Matrixbildners, aus Metallisierungsaktivatoren und gegebenenfalls Füllstoffen besteht. Die mit diesem Hydroprimer beschichteten Substratoberflächen können nach dem Trocknen in chemischen Metallisierungsbädern haftfest mit Metallüberzügen versehen werden. Unter Hydroprimer werden mit Füllstoffen gefüllte und auch ungefüllte wäßrige Polymerdispersionen verstanden.

Der erfindungsgemäße Hydroprimer zum Abscheiden von haftfesten Metallschichten auf Substratoberflächen durch Auftragen einer dünnen Schicht des Hydroprimers auf der Substratoberfläche, gegebenenfalls Sensibilisieren und anschließendes stromloses, naßchemisches Metallisieren besteht im wesentlichen aus
a) einem in Wasser dispersierbaren Polymeren, vorzugsweise einem Polyurethan, in Mengen von 5-60 Gew.-%, vorzugsweise 15-45 Gew.-%,
b) einem Metallisierungskatalysator, im folgenden Aktivator genannt, in Mengen von 0,02-3,5 Gew.-%, vorzugsweise 0,05-0,5 Gew.-%,
c) gegebenenfalls Füllstoffen, in Mengen von 0-70 Gew.-%, vorzugsweise 5-35 Gew.-%,
d) gegebenenfalls sonstigen Bestandteilen in Mengen von 0-15 Gew.-%, vorzugsweise 0-2 Gew.-% und
e) Wasser in Mengen von 20-88 Gew.-%, vorzugsweise 25-50 Gew.-%, jeweils bezogen auf die Gesamtmenge des Hydroprimers.

Der erfindungsgemäße Hydroprimer besitzt den großen Vorteil, daß er im wesentlichen keine organischen Lösungsmittel enthält und somit umweltfreundlich ist. Ein weiterer Vorteil dieses Hydroprimers besteht darin, daß die beschriebene Zusammensetzung dieses Hydroprimers beim Sprühen nicht dazu neigt, Sprühnebel zu ergeben.

Nach dem Aufsprühen und dem Trocknen des Hydroprimers auf den Substratoberflächen können die Substrate in chemischen Metallisierungsbädern haftfest mit unterschiedlichen Metallschichten versehen werden.

In den erfindungsgemäßen Hydroprimern können grundsätzlich alle dispergierbaren Polymere, z.B. Polyacrylate, Polybutadiene, Polyester und Melaminharze eingesetzt werden. Vorzugsweise werden Polyurethane oder Polyurethanharnstoffe, wie sie beispielsweise in der Angewandten Chemie 82 (1970), S. 53-63; DE-A 2 314 512 oder 2 314 513 beschrieben sind, verwendet. Besonders bevorzugte dispergierbare Polyurethane entsprechen der Beschreibung in der DE-A 2 651 506. Diese bevorzugten dispergierbaren Polyurethane besitzen im wesentlichen einen linearen Molekularaufbau und sind gekennzeichnet durch
a) entständige Polyalkylenoxid-polyetherketten mit einem Gehalt an Ethylenoxid-Einheiten von 0,5-10 Gew.-%, bezogen auf das gesamte Polyurethan und
b) einen Gehalt an = N^{⊕} =, -S^{⊕}-, -COO^{⊖} oder -SO₃ ^{⊖}-Gruppen von 0,1-15 Milliäquivalent pro 100 g.

Die Zusammensetzung solcher bevorzugten dispergierbaren Polyurethane und ihre Herstellung sind in der DE-A 2 651 506 eingehend beschrieben. Diese dispergierbaren Polyurethane finden bevorzugt Anwendung, weil sie eine verbesserte thermische Stabilität aufweisen und darüber hinaus gestatten, die für die Metallisierung erforderlichen Aktivatoren in niedrigen Konzentrationen zuzumischen. Die dispergierbaren Polymere werden in Mengen zwischen 5 und 60 Gew.-%, vorzugsweise 15-45 Gew.-% eingesetzt.

Als Aktivatoren kommen in den erfindungsgemäßen Hydroprimern organometallische Verbindungen der ersten und achten Nebengruppen des Periodensystems (insbesondere des Pd, Pt, Au, Ag) in Betracht, wie sie beispielsweise in EP-A 43 485, 81 129, 131 195 beschrieben werden. Einen besonderen Hinweis verdienen die organometallischen Komplex-Verbindungen des Palladiums mit Olefinen (Dienen), mit α-ungesättigten Carbonylverbindungen, mit Kronenethern, mit Nitrilen und mit Diketonen, wie Pentandion.

Ebenfalls kommen ionogene Metalle in Form von Salzen, wie Halogenide, Acetate, Nitrate, Carbonate, Sulfate, Sulfide und Hydroxyde in Betrachz. Auch hier sind es bevorzugt die Salze des Pd, Pt, Au, Ag. Beispiele sind PdS, Na₂PdCl₄, Na₂PdCN₄, H₂PtCl₆, AgNO₃, Ag₂SO₄, Ag₂S.

Erfolgt schon bei der Zugabe der Aktivatoren zu der wäßrigen Dispersion eine Koagulation, so sollte entweder die Konzentration des Aktivators herabgesetzt werden oder ein anderes Salz oder ein anderer Komplex als Aktivator eingesetzt werden.

Besonders gute Ergebnisse werden erzielt mit solchen Verbindungen, bei denen das Edelmetallsalz sehr stark Komplex gebunden ist, beispielsweise das Bis-Acetonitril-Palladiumdichlorid, wenn es zusätzlich noch mit Aminopyridin komplexiert ist, oder der Silberdiamminkomplex [Ag(NH₃)₂]^{⊕} oder aber solche Edelmetallsalze, die in kaltem Wasser relativ schwerlöslich sind, beispielsweise Ag₂SO₄, AgNO₂, Ag-Acetat und AgMnO₄.

Ferner kommen nullwertige Komplexverbindungen wie Palladium(O)-Tetrakis-(Triphenylphosphin) in Betracht.

Als kolloidale Edelmetallsysteme, die ebenfalls als Aktivatoren dienen können, sei auf Pd-Moor, Pd auf Kohle, Pd auf Aluminiumoxid, Pd auf Bariumsulfat und Pd auf A-Kohle hingewiesen.

Vorausgesetzt, daß solche Verbindungen mit den ausgewählten wäßrigen Dispersionen, in die sie eingearbeitet werden sollen, verträglich sind, können auch Gemische solcher Verbindungen eingesetzt werden.

Die Menge des Edelmetalls kann im Bereich von 0,02-3,5 Gew.-% bezogen auf die Hydroprimermasse, breit variiert werden. Die bevorzugte Edelmetallmenge liegt bei 0,025-1,5 Gew.-%, ganz besonders bevorzugt bei 0,05-0,5 Gew.-%.

Als Füllstoffe kommen aus der Druck- bzw. Lackierungstechnik bekannten Hilfsstoffe wie Pigmente, disperse Kieselsäure, Russe oder sonstige Kohlenstoffpulver, Silikate, rheologische Additive und Tonmineralien in Betracht. So kann insbesondere auf die Oxide der Elemente Mn, Ti, Mg, Al, Bi, Cu, Ni, Sn, Zn, Si hingewiesen werden. Bevorzugten Einsatz finden auch Silikate, Bentonite, Talkum und Kreide. Im Rahmen der vorliegenden Erfindung werden besonders bevorzugt Titanoxid und Talkum eingesetzt.

Die Menge des Füllstoffes kann im Bereich von 0,5-70, vorzugsweise jedoch 5-35 Gew.-%, bezogen auf die Masse des Hydroprimers, weit variiert werden. In speziellen Ausführungsformen können sie auch gänzlich fehlen.

Es können auch neben den dispergierbaren Polymeren, Aktivatoren und Füllstoffen gegebenenfalls weitere Bestandteile wie Tenside, Verlaufsmittel, Entschäumer und Farbstoffe in geringen Konzentrationen bis zu 15 Gew.-%, vorzugsweise bis zu 2 Gew.-%, zugemischt werden. Ebenfalls kann sich die Zugabe einer sehr geringen Menge eines Lösungsmittels vorteilhaft auswirken, beispielsweise die Zugabe von 1-9 Vol.-% N-Methylpyrrolidon.

Die Herstellung der erfindungsgemäßen Formulierungen geschieht im allgemeinen durch Vermischen der Bestandteile. Selbstverständlich kann das Einarbeiten der Formulierungskomponenten auch in getrennten Schritten erfolgen. Zur Erzielung einer besonders homogenen Verteilung können Hilfsaggregate wie Kugel- oder Perlmühlen, Skandex oder Red Devil eingesetzt werden.

Der Hydroprimer kann nach den üblichen Methoden wie Bedrucken, Bestempeln, Tauchen, Streichen, Rakeln, Aufpinseln und Aufrollen und Besprühen auf die Kunststoffoberflächen aufgebracht werden. Vorzugsweise durch Aufsprühen der erfindungsgemäßen Primer mittels aus der Lackindustrie bekannter Verfahren können Oberflächen zum Zwecke einer haftfesten chemischen Metallisierung aktiviert werden.

Die Schichtdicke des aufgebrachten Hydroprimers kann im Bereich von 5-200 µm, vorzugsweise jedoch im Bereich von 10-50 µm, variiert werden.

In diesem Zusammenhang sei ausdrücklich erwähnt, däß durch den Einsatz der erfindungsgemäßen Hydroprimer eine quellende oder anätzende Vorbehandlung des Kunststoffs nicht erforderlich ist. Ein Auftreten von Spannungsrissen ist daher nicht möglich.

Als Substrate für das erfindungsgemäße Verfahren eignen sich Werkstücke auf Basis von anorganischen Gläsern, Metallen und insbesondere Kunststoffen. Besonders bevorzugt sind Kunststoffe, wie sie im Elektro-, Elektronik- und Haushaltsbereich eingesetzt werden. In diesem Zusammenhang sei auf ABS, Polycarbonat und deren Mischungen, sowie auf deren flammfest ausgerüstete Typen wie z.B. Bayblend^{R} FRZ90, 1441, 1439 und 1448 hingewiesen. Weitere Beispiele für Kunststoffe sind: Polyamide, Polyestertypen, z.B. auch Polybutylenterephthalat, PVC, Polyethylen und Polypropylen, Polyphenylensulfid, Polyphenylenoxid und Polyurethane.

Nach dem Aufbringen der erfindungsgemäßen Formulierungen auf die Oberfläche der Substrate wird das Wasser durch Trocknen entfernt. Dies geschieht bei substratspezifischen Temperaturen, beispielsweise zwischen Raumtemperatur und 200°C unter Normaldruck oder im Vakuum. Die Trocknungszeit kann dabei variiert werden.

Die so behandelten Oberflächen müssen gegebenenfalls anschließend durch Reduktion sensibilisiert werden. Dazu können bevorzugt die in der Galvanotechnik üblichen Reduktionsmittel, wie Hydrazinhydrat, Formaldehyd, Hypophosphit und Borane, beispielsweise Dimethylaminboran, verwendet werden. Natürlich sind auch andere Reduktionsmittel möglich. Bevorzugt wird die Reduktion in wäßriger Lösung durchgeführt. Es sind aber auch andere Lösungsmittel wie Alkohole, Ether, Kohlenwasserstoffe einsetzbar. Selbstverständlich können auch Suspensionen oder Ausschlemmungen der Reduktionsmittel verwendet werden.

Die so aktivierten Oberflächen können direkt zur stromlosen Metallisierung eingesetzt werden. Es kann aber auch erforderlich sein, die Oberfläche durch Spülen von Reduktionsmittelresten zu reinigen.

Eine bevorzugte Ausführungsform des erfindungsgemäßen Verfahrens besteht darin, daß die Reduktion im Metallisierungsbad gleich mit dem Reduktionsmittel der stromlosen Metallisierung durchgeführt wird. Diese Ausführung stellt eine Vereinfachung des Metallisierungsprozesses dar. Diese vereinfachte Ausführungsform des Verfahrens besteht nur noch aus 3 Arbeitsgängen: Aufbringen, insbesondere Aufsprühen des Hydroprimers, Trocknen und Eintauchen der so aktivierten Oberflächen in das Metallisierungsbad. Diese Ausführungsform ist ganz besonders für aminboranhaltige Nickelbäder oder formalinhaltige Kupferbäder geeignet

Als in dem erfindungsgemäßen Verfahren einsetzbare Metallisierungsbäder kommen bevorzugt solche in Betracht, aus denen Nickel, Kobalt, Kupfer, Gold oder Silber sowie der Gemische untereinander oder mit Eisen abgeschieden werden können. Derartige Metallisierungsbäder sind in der Technik der stromlosen Metallisierung bekannt.

Das erfindungsgemäße Verfahren hat den Vorteil, daß es auch ohne vorhergehende oxidatives Ätzen und/oder Quellen bzw. Behandeln mit Polymerketten aufweisenden Lösungsmitteln der Substratoberfläche ausgeführt werden kann. Die haftfeste Metallabscheidung wird erzielt mit Hilfe des zur Metallisierung befähigten Hydroprimerauftrags.

Das Verfahren hat darüber hinaus den Vorteil, daß es ohne jegliches organisches Lösungsmittel oder nur mit geringen Mengen eines organischen Lösungsmittels durchgeführt werden kann, wodurch es sich als besonders umweltfreundlich qualifiziert.

Somit ermöglicht das neue Verfahren eine materialschonende und besonders umweltfreundliche, kostengünstige, sowohl ganzflächige als auch partielle Metallabscheidung auf Werkstoffoberflächen.

Nach dem neuen Verfahren metallisierte Werkstoffe zeichnen sich durch ihre hervorragende Abschirmung gegenüber elektromagnetischen Wellen aus. Die so ausgerüsteten Werkstoffe finden Verwendung im Elektro-, Automobil-, Elektronik- und Haushaltsbereich.

Die guten mechanischen Eigenschaften des polymeren Basismaterials bzgl. Schlagzähigkeit, Kerbschlagzähigkeit, Biegefestigkeit und Randdehnung werden durch den Lackierungs- bzw. Metallisierungsvorgang nicht negativ beeinflußt.

### Beispiele

### Beispiel 1

Eine 100 x 200 mm große Testplatte aus einem Blend, bestehend aus 60 % eines Polyesters aus 4,4'-Dihydroxydiphenyl-2,2-propan und Kohlensäure und 40 % Acrylnitril-Butadien-Styrol-Copolymerisat mit einer Vicattemperatur von ca. 90°C, wurde durch Besprühen einseitig mit einer Hydroprimerschicht versehen und bei 65°C im Verlauf von 45 Minuten getrocknet. Die Trockenschichtdicke betrug ca. 40 µm.

### Der Hydroprimer bestand aus

- 624 Gew.-Teilen: einer 40 %igen wäßrigen Dispersion eines Polyurethans bestehend aus linearen, leicht verzweigten aliphatischen Ketten, die -COO⁻ bzw. -SO₃ ⁻-Gruppen eingebaut, enthalten gemäß der DE-A 2 651 506 mit einer Teilchengröße von 50 bis 450 nm
- 100 Gew.-Teilen: TiO₂
- 200 Gew.-Teilen: Talkum und
- 76 Gew.-Teilen: einer wäßrigen Lösung, die 3,5 Gew.-Teile (bezogen auf das Gesamtgewicht des Hydroprimers von 1000 Gew.-Teilen) des Silberdiamminkomplexes [Ag(NH₃)₂]⁺ enthielt.

Die Testplatte wurde in einem Reduktionsbad, bestehend aus 10 g Dimethylaminboran und 1,0 g NaOH in 1 Liter Wasser 10 Minuten lang bei 30°C behandelt und anschließend bei Raumtemperatur in einem handelsüblichen chemischen Verkupferungsbad im Verlaufe von 30 Minuten verkupfert, mit destilliertem Wasser gewaschen und anschließend bei 65°C 30 Minuten lang getrocknet.

Man bekam eine einseitig metallisierte Platte mit einer 1,9 µm starken Kupferschicht. Diese Platte war außerordentlich gut gegenüber elektromagnetischen Wellen abschirmend. Bei 27 MHz wurden im Nahfeld 35 dB gemessen.

Die Metallauflage haftete an der Kunststoffoberfläche so gut, daß sie sowohl den Tesafilmtest nach DIN 53 151, als auch einen Wechseltemperaturtest mit Temperaturwechseln zwischen -40 und +70°C sehr gut bestand.

Ferner wies die Metallauflage eine Abzugsfestigkeit nach DIN 53 494 von 25 N/25 mm auf.

Wurde anstelle der Testplatte aus dem oben beschriebenen Blend eine ebenso große Platte aus Polyamid oder aus einem Polyurethan eingesetzt, so wurden ebenfalls hervorragende Ergebnisse erhalten.

### Beispiel 2

Eine 100 x 200 mm große ABS-Platte wurde mit einem Hydroprimer, bestehend aus
- 652 Gew.-Teilen: einer 40 %igen wäßrigen Dispersion eines Polyurethans bestehend aus linearen, leicht verzweigten aliphatischen Ketten, die COO⁻ bzw. -SO₃ ⁻-Gruppen eingebaut, enthalten gemäß der DE-A 2 651 506 mit einer Teilchengröße von 50 bis 450 nm
- 115 Gew.-Teilen: TiO₂
- 230 Gew.-Teilen: Talkum und
- 3 Gew.-Teilen: Ag₂SO₄
mittels eines Sprühroboters mit einer ca. 15 µm dicken Schicht einseitig beschichtet, dann nach Beispiel 1 sensibilisiert und verkupfert und bei 70°C 20 Minuten getempert. Man bekam eine gegenüber elektromagnetischen Wellen sehr gut abschirmende Kunststoffplatte mit guter Metallhaftung. Die Haftung der Metallauflage nach DIN 53 494 betrug 20 N/25 mm.

### Beispiel 3

Eine 100 x 200 mm große Testplatte, bestehend aus ca. 70 % eines Polyesters aus 4,4'-Dihydroxydiphenyl-2,2-propan und Kohlensäure, wurde nach Beispiel 1 mit einer Hydroprimerschicht und dann mit einer Metallauflage versehen. Man bekam eine gegenüber elektromagnetischen Wellen gut abschirmende Platte mit einer guten Metallhaftung.

Die Metallauflage wies eine Abzugsfestigkeit nach DIN 53 494 von 20 N/25 mm auf. Ebenso wurde der in Beispiel 1 beschriebene Wechseltemperaturtest gut bestanden.

### Beispiel 4

Eine 100 x 200 mm große Polyphenylenoxid/Polystyrol-Platte wurde mit einem Hydroprimer, bestehend aus
- 920 Gew.-Teilen: einer 40 %igen wäßrigen Dispersion eines Polyurethans bestehend aus linearen, leicht verzweigten aliphatischen Ketten, die -COO⁻ bzw. -SO₃ ⁻-Gruppen eingebaut, enthalten gemäß der DE-A 2 651 506 mit einer Teilchengröße von 50 bis 450 mm und
- 80 Gew.-Teilen: einer wäßrigen Lösung, die 5 Gew.-Teile (bezogen auf die Gesamtmenge des Hydroprimers von 1000 Gew.-Teilen) des Bis-Acetonitril-Palladiumdichlorid-Komplexes, der zusätzlich mit 2-Aminopyridin komplexiert war, enthielt,
einseitig versehen und bei 60°C im Verlaufe von 45 Minuten getrocknet.

Die den Hydroprimer enthaltende Platte wurde in einem chemischen Verkupferungsbad im Verlaufe von 40 Minuten mit einer 2,6 µm starken Cu-Auflage überzogen.

Man bekam eine einseitig metallisierte Kunststoffplatte mit einer guten Metallhaftung. Die Haftfestigkeit betrug nach DIN 53 494 12 N/25 mm.

Diese Platte war gegenüber elektromagnetischen Wellen außerordentlich gut abschirmend.

## Patentansprüche

1. Hydroprimer zum Abscheiden von haftfesten Metallschichten auf Substratoberflächen durch Auftragen einer dünnen Schicht des Hydroprimers auf der Substratoberfläche, gegebenenfalls Sensibilisieren und anschließendes stromloses, naßchemisches Metallisieren, bestehend im wesentlichen aus
a) einem in Wasser dispergierbares Polymer, vorzugsweise einem Polyurethan, in Mengen von 5-60 Gew.-%, vorzugsweise 15-45 Gew.-%,
b) einem Metallisierungskatalysator aus Edelmetallverbindungen, in Mengen von 0,02-3,5 Gew.-%, vorzugsweise 0,05-0,5 Gew.-%,
c) gegebenenfalls Füllstoffen, in Mengen von 0-70 Gew.-%, vorzugsweise 5-35 Gew.-%,
d) gegebenenfalls sonstigen Bestandteilen aus der Gruppe der Tenside Verlaufsmittel, Entschäumer und Farbstoffe in Mengen von 0-15 Gew.-%, vorzugsweise 0-2 Gew.-% und
e) Wasser in Mengen von 20-88 Gew.-%, vorzugsweise 25-50 Gew.-%, jeweils bezogen auf die Gesamtmenge des Hydroprimers.

2. Hydroprimer nach Anspruch 1, dadurch gekennzeichnet, daß das in Wasser dispergierbare Polymer aus einem Polyurethan mit vorwiegend linearen Molekularaufbau besteht und
a) entständige Polyalkylenoxid-Polyetherketten mit einem Gehalt an Ethylenoxid-Einheiten von 0,5-10 Gew.-% bezogen auf das gesamte Polyurethan und
b) einen Gehalt an =N^{⊕}=, -S^{⊕}-, -COO^{⊖} oder -SO₃ ^{⊕}-Gruppen von 0,1-15 Milliäquivalent
enthält.

3. Hydroprimer nach Anspruch 1, dadurch gekennzeichnet, daß er Komplexverbindungen oder anorganische Salze der Elemente Cu, Au, Ag, Pt, Pd oder Ru in Mengen zwischen 0,02-3,5 Gew.-%, bevorzugt 0,05-0,5 Gew.-%, bezogen auf die Hydroprimermasse, enthält.

4. Hydroprimer nach Anspruch 4, dadurch gekennzeichnet, daß er als Metallkomplex das Bis-Acetonitril-Palladiumdichlorid, das zusätzlich mit 2-Aminopyridin komplexiert ist, enthält.

5. Hydroprimer nach Anspruch 3, dadurch gekennzeichnet, daß er den Silberdiamminkomplex [Ag(NH₃)₂]^{⊕} enthält.

6. Hydroprimer nach Anspruch 3, dadurch gekennzeichnet, daß er die in kaltem Wasser relativ schwerlöslichen Silbersalze Ag₂SO₄, Ag₂NO₂, Ag-Acetat und AgMnO₄ enthält.

7. Hydroprimer nach Anspruch 1, dadurch gekennzeichnet, daß er als Füllstoffe Silikate, Bentonite, Talkum und/oder Kreide, sowie Oxide der Elemente Mn, Ti, Mg, Al, Bi, Cu, Ni, Sn, Zn und Si, bevorzugt Titandioxid und/oder Talkum, in einer Menge von 5-35 Gew.-%, bezogen auf die Masse des Hydroprimers, enthält.

8. Verfahren zur Beschichtung von Substratoberflächen für deren stromlose Metallisierung dadurch gekennzeichnet, daß diese mit einem Hydroprimer gemäß Anspruch 1 behandelt werden, wobei vor der naßchemischen Metallisierung eine Sensibilisierung mit Reduktionsmitteln wie Formalin, Dimethylaminboran oder Hydrazin vorgenommen werden kann.

9. Verwendung des Hydroprimers nach Anspruch 1 zur Herstellung von metallisierten Formkörpern für die Abschirmung elektromagnetischer Wellen.

## Claims

1. Hydroprimer for the deposition of firmly adhering metal coatings onto substrate surfaces by application of a thin layer of the hydroprimer to the substrate surface; if appropriate sensitisation and subsequent currentless wet-chemical metallisation, essentially comprising
a) a water-dispersible polymer, preferably a polyurethane, in amounts of 5-60% by weight, preferably 15-45% by weight,
b) a metallisation catalyst of noble metal compounds in amounts of 0.02-3.5% by weight, preferably 0.05-0.5% by weight,
c) if appropriate fillers, in amounts of 0-70% by weight, preferably 5-35% by weight,
d) if appropriate other constituents from the group comprising the surface-active agents, levelling agents, antifoam agents and dyestuffs in amounts of 0-15% by weight, preferably 0-2% by weight, and
e) water in amounts of 20-88% by weight, preferably 25-50% by weight, in each case based on the total amount of the hydroprimer.

2. Hydroprimer according to Claim 1, characterised in that the water-dispersible polymer consists of a polyurethane having a predominantly linear molecular structure and
a) terminal polyalkylene oxide-polyether chains having a content of ethylene oxide units of 0.5-10% by weight, based on the total polyurethane, and
b) a content of =N^{⊕}=, -S^{⊕}-, -COO^{^{⊕}} or -SO₃ ^{⊕} groups of 0.1-15 milliequivalents.

3. Hydroprimer according to Claim 1, characterised in that it contains complex compounds or inorganic salts of the elements Cu, Au, Ag, Pt, Pd or Ru in amounts of between 0.02-3.5% by weight, preferably 0.05-0.5% by weight, based on the hydroprimer composition.

4. Hydroprimer according to Claim 4, characterised in that it contains bis-acetonitrile-palladium dichloride, which is additionally complexed with 2-aminopyridine, as the metal complex.

5. Hydroprimer according to Claim 3, characterised in that it contains the silver diammine complex [Ag(NH₃)₂]^{⊕}.

6. Hydroprimer according to Claim 3, characterised in that it contains the silver salts Ag₂SO₄, Ag₂NO₂, Ag acetate and AgMnO₄ which are relatively sparingly soluble in cold water.

7. Hydroprimer according to Claim 1, characterised in that it contains silicates, bentonites, talc and/or chalk, as well as oxides of the elements Mn, Ti, Mg, Al, Bi, Cu, Ni, Sn, Zn and Si, preferably titanium dioxide and/or talc, as fillers in an amount of 5-35% by weight, based on the mass of the hydroprimer.

8. Process for coating substrate surfaces for currentless metallisation thereof, characterised in that these are treated with a hydroprimer according to Claim 1, it being possible for sensitisation with reducing agents, such as formalin, dimethylaminoborane or hydrazine, to be carried out before the wet/chemical metallisation.

9. Use of the hydroprimer according to Claim 1 for the production of metallised shaped articles for shielding from electromagnetic waves.

## Revendications

1. Peinture d'apprêt ou de fond aqueuse pour le dépôt de couches métalliques très adhérentes sur des surfaces de substrats par application d'une couche mince de la peinture d'apprêt aqueuse sur la surface du substrat, par sensibilisation éventuelle et par métallisation chimique ultérieure par voie humide sans courant, constituée essentiellement par
a) un polymère apte à être dispersé dans l'eau, de préférence un polyuréthanne, dans des quantités de 5-60% en poids, de préférence de 15-45% en poids,
b) un catalyseur de métallisation constitué par des composés de métaux nobles dans des quantités de 0,02-3,5% en poids, de préférence de 0,05-0,5% en poids,
c) éventuellement des matières de remplissage dans des quantités de 0-70% en poids, de préférence de 5-35% en poids,
d) éventuellement d'autres composants choisis parmi le groupe des agents tensioactifs, des agents nivelants, des agents antimousse et des colorants dans des quantités de 0-15% en poids, de préférence de 0-2% en poids, et
e) de l'eau dans des quantités de 20-88% en poids, de préférence de 25-50% en poids, respectivement rapportées à la quantité totale de la peinture d'apprêt aqueuse.

2. Peinture d'apprêt aqueuse selon la revendication 1, caractérisée en ce que le polymère apte à être dispersé dans l'eau est constitué par un polyuréthanne présentant une composition moléculaire principalement linéaire et contient
a) des chaînes terminales d'oxydes de polyalkylènespolyéthers possédant une teneur en unités d'oxyde d'éthylène de 0,5-10% en poids, rapportée au polyuréthanne total et
b) une teneur en groupes =N^{⊕}=, -S^{⊕}-, -COO^{⊖} ou -SO₃ ^{⊕} de 0,1-15 milliéquivalents.

3. Peinture d'apprêt aqueuse selon la revendication 1, caractérisée en ce qu'elle contient des composés complexes ou des sels inorganiques des éléments Cu, Au, Ag, Pt, Pd ou Ru dans des quantités entre 0,02 -3,5% en poids, de préférence de 0,05-0,5% en poids, rapportées à la masse de la peinture d'apprêt aqueuse.

4. Peinture d'apprêt aqueuse selon la revendication 3, caractérisée en ce qu'elle contient, comme complexe métallique, le bis-acétonitrile-dichlorure de palladium qui est en outre complexé avec la 2-aminopyridine.

5. Peinture d'apprêt aqueuse selon la revendication 3, caractérisée en ce qu'elle contient le complexe d'argento-diammine [Ag(NH₃)₂]^{⊕}.

6. Peinture d'apprêt aqueuse selon la revendication 3, caractérisée en ce qu'elle contient les sels d'argent Ag₂SO₄, Ag₂NO₂, l'acétate d'argent et AgMnO₄ relativement peu solubles dans l'eau froide.

7. Peinture d'apprêt aqueuse selon la revendication 1, caractérisée en ce qu'elle contient, comme matières de remplissage, des silicates, la bentonite, le talc et la craie, ainsi que des oxydes des éléments Mn, Ti, Mg, Al, Bi, Cu, Ni, Sn, Zn et Si, de préférence le dioxyde de titane et/ou le talc, en une quantité de 5-35% en poids, rapportée à la masse de la peinture d'apprêt aqueuse.

8. Procédé pour l'enduction de surfaces de substrats pour leur métallisation sans courant, caractérisé en ce qu'on traite ces dernières avec une peinture d'apprêt aqueuse selon la revendication 1, dans lequel, avant la métallisation chimique par voie humide, on peut procéder à une sensibilisation avec des agents de réduction tels que la formaline, le diméthylaminoborane ou l'hydrazine.

9. Utilisation de la peinture d'apprêt aqueuse selon la revendication 1, pour la préparation de corps moulés métallisés à des fins de blindage contre des ondes électromagnétiques.
